(19) Europäisches Patentamt / European Patent Office / Office européen des brevets

(11) **EP 4 320 723 B1**

(12) **EUROPEAN PATENT SPECIFICATION**

(45) Date of publication and mention of the grant of the patent:
**26.02.2025 Bulletin 2025/09**

(21) Application number: **22715569.4**

(22) Date of filing: **15.03.2022**

(51) International Patent Classification (IPC):
*H03F 1/32* (2006.01)    *H03F 3/24* (2006.01)
*H03F 3/195* (2006.01)

(52) Cooperative Patent Classification (CPC):
**H03F 1/3247; H03F 1/3294; H03F 3/195;**
**H03F 3/245;** H03F 2200/451; H03F 2201/3209

(86) International application number:
**PCT/EP2022/056698**

(87) International publication number:
**WO 2022/214278 (13.10.2022 Gazette 2022/41)**

(54) **DIGITAL PRE-DISTORTION USING CONVOLUTIONAL NEURAL NETWORKS**

DIGITALE VORVERZERRUNG UNTER VERWENDUNG NEURONALER FALTUNGSNETZE

PRÉDISTORSION NUMÉRIQUE À L'AIDE DE RÉSEAUX NEURONAUX CONVOLUTIONNELS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.04.2021  FI 20215423**

(43) Date of publication of application:
**14.02.2024  Bulletin 2024/07**

(73) Proprietor: **Nokia Solutions and Networks Oy**
**02610 Espoo (FI)**

(72) Inventors:
• **VU, Trung Kien**
  **01700 Vantaa (FI)**
• **HU, Fei**
  **90620 Oulu (FI)**
• **XIONG, Xue Quan**
  **90620 Oulu (FI)**
• **NEIJONEN, Antti**
  **90620 Oulu (FI)**
• **TOLONEN, Jukka Petteri**
  **90620 Oulu (FI)**
• **SAVOLAINEN, Jarkko Johannes**
  **90620 Oulu (FI)**
• **WANG, Ziming**
  **90620 Oulu (FI)**

(74) Representative: **Nokia EPO representatives**
**Nokia Technologies Oy**
**Karakaari 7**
**02610 Espoo (FI)**

(56) References cited:
**EP-A1- 2 538 553**

• LIU TAIJUN ET AL: "Digital Predistortion Linearization with Deep Neural Networks for 5G Power Amplifiers", 2019 EUROPEAN MICROWAVE CONFERENCE IN CENTRAL EUROPE (EUMCE), EUMCE, 13 May 2019 (2019-05-13), pages 216 - 219, XP033634609
• LI GANG ET AL: "Instant Gated Recurrent Neural Network Behavioral Model for Digital Predistortion of RF Power Amplifiers", IEEE ACCESS, IEEE, USA, vol. 8, 13 April 2020 (2020-04-13), pages 67474 - 67483, XP011784352, DOI: 10.1109/ACCESS.2020.2986816
• SUN JINLONG ET AL: "Adaptive Deep Learning Aided Digital Predistorter Considering Dynamic Envelope", IEEE TRANSACTIONS ON VEHICULAR TECHNOLOGY, IEEE, USA, vol. 69, no. 4, 17 February 2020 (2020-02-17), pages 4487 - 4491, XP011784005, ISSN: 0018-9545, [retrieved on 20200416], DOI: 10.1109/TVT.2020.2974506

**Description**

**Background**

In base transceiver stations (BTS or base stations), the power amplifier (PA) is often the component that consumes the most energy. Improving the efficiency of operation of the PA improves both data throughput and energy expenditure. However, it is challenging to ensure efficient PA operation. This is not least because, when the PA is driven with high peak-to-average power ratio (PAPR), it introduces non-linearity into the system. This non-linearity generates spectral re-growth, which leads to an increase in the adjacent channel interference ratio (ACLR) and out-of-band emissions.

For nearly three decades, digital pre-distortion (DPD) has been used to compensate for non-linearity introduced by PAs. DPD is typically implemented in the digital baseband to allow the PA to operate more efficiently at high PAPR.

Conventional DPD techniques attempt to mathematically model, using a memory polynomial (MP) model, the distortion of the PA. The DPD apparatus 10 then applies the inverse of this model to the input signal to generate the distorted signal which is passed to the PA 12. However, in current and future wireless communication systems, such conventional DPD techniques face several problems. This is at least in part due to use of higher operating frequency bands, wider bandwidths, and multiple power amplifiers use cases. To model the distortion of the PA in such circumstances, a vast number of coefficients is required (e.g. from 50 coefficients to several hundred coefficients), and the performance can be insufficient.

Some recent works have applied deep learning to the problem. For instance, recurrent neural networks (RNN) or long-short term memory (LSTM) have been used under a common belief that RNN or LSTM networks could learn the non-linearity and capture the memory effect of the signal. However, such works have either obtained low performance or good performance but at the cost of high model complexity.

Such models are not practical for deployment in state-of-the-art embedded systems such as field-programmable gate arrays (FPGAs) and application-specific integrated circuits (ASICs).

EP 2 538 553 A1 discloses a concept for mitigating impairments due to transmit noise. An apparatus is disclosed for mitigating transmitter impairments of a transmit signal, the apparatus comprising an input for an in-phase and a quadrature component of a digital baseband transmit signal, a pre-distortion neural network processor for pre-distorting the input digital baseband transmit signal to obtain a pre-distorted digital baseband signal, wherein the pre-distortion neural network processor is adaptable to a transmitter transfer function of at least one analog transmitter device arranged downstream to the pre-distortion neural network processor such that a transfer function of the pre-distortion neural network processor approximates an inverse of said transmitter transfer function, and an output for an in-phase and a quadrature component of the pre-distorted digital baseband signal, which may be coupled to an input of the at least one analog transmitter device arranged downstream to the pre-distortion neural network processor.

**Summary**

The scope of protection sought for various embodiments of the invention is set out by the independent claims. The embodiments and features, if any, described in this specification that do not fall under the scope of the independent claims are to be interpreted as examples useful for understanding various embodiments of the invention.

There is described an apparatus comprising means for pre-distorting an input signal, that is to be amplified by a power amplifier, by processing, by a first neural network block comprising multiple convolutional neural network layers, input data representing in-phase, I, and quadrature, Q, signals of the input signal to generate a first neural network block output, and processing, by a second neural network block comprising at least one dilated convolutional neural network layer, the input data to generate a second neural network block output. The first neural network block output and the second neural network block output are then combined to generate a pre-distorted signal for amplification by the power amplifier.

The processing, by the first neural network block, the input data to generate the first neural network block output may comprise processing, by a first neural network processing path of the first neural network block, the input data to generate a first neural network processing path output. In addition, it may comprise determining, based on the input data, second input data representing power values of the I and Q signals of the input data, and processing, by a second neural network processing path of the first neural network block, the second input data to generate a second neural network processing path output. The first neural network processing path output and the second neural network processing path output may then be combined, for instance by multiplication, to generate the first neural network block output. The first neural network processing path may comprise one or more convolutional neural network layers and the second neural network processing path may comprise one or more convolutional neural network layers.

Combining the first neural network block output and the second neural network block output to generate the pre-distorted signal may comprise processing the first neural network block output and the second neural network block output using a linear transformation block, having plural linear transformation coefficients, to generate the pre-distorted signal.

The means may be further configured to receive data representing an amplified signal produced by amplification of the pre-distorted signal by the power amplifier, and, based on the data representing the amplified signal, adapt the linear transformation coefficients of the linear transformation block. In contrast, coefficients of the first and second neural network processing blocks may not be adapted. The linear transformation coefficients of the linear transformation block may be adapted using a least mean square method.

Coefficients of the first neural network block and the second neural network block and initial linear transformation coefficients of the linear transformation block may be determined during end-to-end training. The first neural network block, the second neural network block and the linear transformation block may have been trained to mimic ideal digital pre-distortion for the power amplifier. The first neural network block, the second neural network block and the linear transformation block may have been trained by: passing an input training data sample, representing I and Q signals of a training input signal portion, through the first neural network block; passing the input training data sample through the second neural network block; processing outputs of the first neural network block and the second neural network block using the linear transformation block to generate a pre-distorted training output signal portion; comparing the pre-distorted training output signal portion with an ideal pre-distorted signal portion for the power amplifier; and updating coefficients of one or more of the first neural network block, the second neural network block, and the linear transformation block based on the comparison. The ideal pre-distorted signal portion may have been obtained by performing multiple iterations of: processing a cyclical signal using a pre-distortion algorithm to generate a pre-distorted cyclical signal; passing the pre-distorted cyclical signal through a power amplifier to generate an amplified cyclical signal; comparing the amplified cyclical signal with the cyclical signal; optimising the pre-distortion algorithm based on the comparison. The training input signal portion may be a portion of the cyclical signal and the ideal pre-distorted output signal portion may be the output of the optimised pre-distortion algorithm resulting from processing the portion of the cyclical signal.

The activation function for at least some of the convolutional neural network layers may be a tanh activation function. At least some of the convolutional neural network layers may apply a depthwise separable convolution. The apparatus may be an application specific integrated circuit or a field programmable gate array.

There is described an apparatus comprising at least one processor and at least one non-transitory memory medium storing computer readable code and a machine-learned model. The machine-learned model comprises a first neural network block comprising multiple convolutional neural network layers, a second neural network block comprising at least one dilated convolutional neural network layer, and a linear transformation block. When executed, the computer readable code causes the at least one processor to receive input data representing in-phase, I, and quadrature, Q, signals of an input signal that is to be amplified by a power amplifier, process the received input data using the first neural network block of the machine learned model to generate a first neural network block output, and process the received input data using the second neural network block of the machine learned model to generate a second neural network block output. The linear transformation block may then be used to combine the first neural network block output and the second neural network block output to generate a pre-distorted signal for amplification by the power amplifier.

The processing, using the first neural network block, the received input data to generate the first neural network block output may comprise processing, by a first neural network processing path of the first neural network block, the input data to generate a first neural network processing path output. In addition, it may comprise determining, based on the input data, second input data representing power values of the I and Q signals of the input data, and processing, by a second neural network processing path of the first neural network block, the second input data to generate a second neural network processing path output. The first neural network processing path output and the second neural network processing path output may then be combined, for instance by multiplication, to generate the first neural network block output. The first neural network processing path may comprise one or more convolutional neural network layers and the second neural network processing path may comprise one or more convolutional neural network layers.

The linear transformation block may have plural linear transformation coefficients, based on which the first neural network block output and the second neural network block output are combined. The computer readable code may further cause the at least one processor to receive data representing an amplified signal produced by amplification of the pre-distorted signal by the power amplifier, and, based on the data representing the amplified signal, adapt the linear transformation coefficients of the linear transformation block. In contrast, coefficients of the first and second neural network processing blocks may not be adapted. The linear transformation coefficients of the linear transformation block may be adapted using a least mean square method.

Coefficients of the first neural network block and the second neural network block and initial linear transformation coefficients of the linear transformation block may be determined during end-to-end training. The first neural network block, the second neural network block and the linear transformation block may have been trained to mimic ideal digital pre-distortion for the power amplifier. The first neural network block, the second neural network block and the linear transformation block may have been trained by: passing an input training data sample, representing I and Q signals of a training input signal portion, through the first neural network block; passing the input training data sample through the second neural network block; processing outputs of the first neural network block and the second neural network block using the linear transformation block to generate a pre-distorted training output signal portion; comparing the pre-distorted training output signal portion with an ideal pre-distorted signal portion for the power amplifier; and updating coefficients of one or more of the first neural network block, the second neural network block, and the linear transformation block based on the comparison. The ideal pre-distorted signal portion may have been obtained by performing multiple iterations of: processing a cyclical signal using a pre-distortion algorithm to generate a pre-distorted cyclical signal; passing the pre-distorted cyclical signal through a power amplifier to generate an amplified cyclical signal; comparing the amplified cyclical signal with the cyclical signal; optimising the pre-distortion algorithm based on the comparison. The training input signal portion may be a portion of the cyclical signal and the ideal pre-distorted output signal portion may be the output of the optimised pre-distortion algorithm resulting from processing the portion of the cyclical signal.

The activation function for at least some of the convolutional neural network layers may be a tanh activation function. At least some of the convolutional neural network layers may apply a depthwise separable convolution. The apparatus may be an application specific integrated circuit or a field programmable gate array.

This specification describes one or more non-transitory computer readable medium storing a machine-learned model comprising a first neural network block comprising multiple convolutional neural network layers, a second neural network block comprising at least one dilated convolutional neural network layer, and a linear transformation block. The one or more non-transitory computer readable medium may further store computer readable code, which when executed causes the at least one processor to receive input data representing in-phase, I, and quadrature, Q, signals of an input signal that is to be amplified by a power amplifier, process the received input data using the first neural network block of the machine learned model to generate a first neural network block output, and process the received input data using the second neural network block of the machine learned model to generate a second neural network block output. The linear transformation block may then be used to combine the first neural network block output and the second neural network block output to generate a pre-distorted signal for amplification by the power amplifier.

This specification describes a computer-implemented method for distorting an input signal, that is to be amplified by a power amplifier, The method comprises processing, by a first neural network block comprising multiple convolutional neural network layers, input data representing in-phase, I, and quadrature, Q, signals of the input signal to generate a first neural network block output, and processing, by a second neural network block comprising at least one dilated convolutional neural network layer, the input data to generate a second neural network block output. The first neural network block output and the second neural network block output are then combined to generate a pre-distorted signal for amplification by the power amplifier.

## Brief Description of the Figures

Aspects of the present disclosure will now be described by way of non-limiting example, with reference to the accompanying drawings, in which:

FIG. 1A illustrates the concept of digital pre-distortion;

FIG. 1B is a schematic illustration of a digital pre-distortion apparatus;

FIG. 2 is a schematic illustration of a digital pre-distortion apparatus provided within a transmitter such as a BTS;

FIG. 3 is a schematic illustration of a digital pre-distortion architecture according to example aspects of the present disclosure;

FIG. 4A is a schematic illustration of a first example neural network block which may form part of the digital pre-distortion architecture of Figure 3;

FIG. 4B is a schematic illustration of a second example neural network block which may form part of the digital pre-distortion architecture of Figure 3;

FIG. 5 is a schematic illustration of an example neural network processing path which may be utilised in the example neural network blocks of FIGs. 4A and 4B;

FIG. 6 is a schematic illustration of an example neural network layer which may be utilised in the example neural network processing path of FIG. 5;

FIG. 7 is a flow chart of example operations which may be performed when training a DPD model according to some example aspects of the present disclosure;

FIG. 8 is a flow chart of example operations which may be performed when performing digital pre-distortion using a digital pre-distortion architecture such as that illustrated in FIG. 3;

FIG. 9 is a schematic illustration a digital pre-distortion apparatus provided within an example context;

FIG. 10 is a schematic illustration of an apparatus that may be configured according to various examples described herein; and

FIG. 11 is a schematic illustration of a non-transitory medium which may carry computer-readable code and/or data representing a DL-DPD model according to some examples.

## Detailed Description

Example aspects described herein may relate to digital pre-distortion, and more specifically to digital pre-distortion for compensating for non-linearity in power amplifiers.

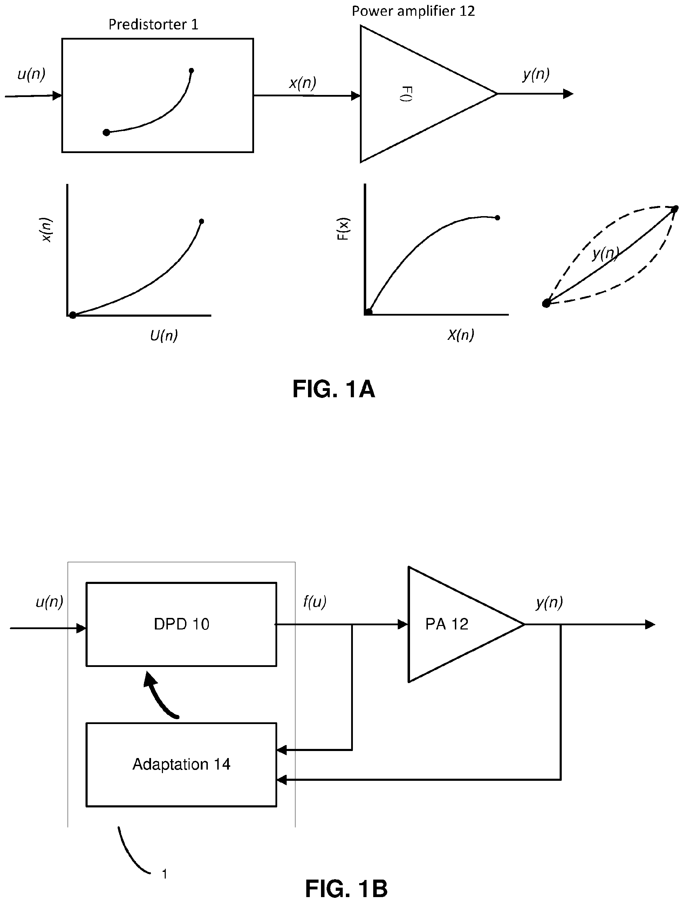

Figures 1A and 1B illustrate the concept of digital pre-distortion (DPD), in which the pre-distortion is added by a pre-distortion apparatus 10 to an input signal, u(n), to produce an ideally pre-distorted signal, x(n). The pre-distorted signal is then provided to the power amplifier (PA) 12. The pre-distortion results in a cancellation of the PA's own distortion so that output of the PA $y(n)$ is, in effect, a linearly amplified version of the input signal u(n).

As illustrated in FIG. 1B, u(n) is the input signal to the pre-distortion module 1 and $f(u)$ is the output of the pre-distortion module 1. The PA 12 then uses the pre-distorted signal $f(u)$ as its input signal and produces an output signal y(n) such that y(n)= $F(f(u))$, where $F(\cdot)$ denotes the amplifier function.

The pre-distortion module 1 comprises a pre-distortion (DPD) block 10 and an adaptation block 14. The pre-distortion block 10 acts as an approximation function $f(\cdot)$ to generate the pre-distorted signal $f(u)$, which for ideal pre-distortion for the power amplifier would be equal to x(n). The goal of the DPD module 1 is to mimic the ideal pre-distorted signal x(n) so as to minimize a loss function $g(\cdot)$ between $x(n)$ and $f(u)$, where $g(x,u)=g(x,f(u))$.

In a conventional, mathematical model-based pre-distortion approach, the minimization of the loss function $g(\cdot)$ may be achieved by determination of an appropriate mathematical model for use by the DPD block 10. The adaptation block 14 may be used to adaptively adjust coefficients of the pre-distortion block 10 based on the output $y(n)$ of the PA 12, thereby to maintain minimization of the loss function $g(\cdot)$ as far as possible. The adaptation block therefore allows the DPD block 1 to respond, for instance, to changes in the incoming signal. Figure 1B illustrates an indirect learning based adaptation approach, where the adaptation block uses both $y(n)$ and $f(u)$ to perform adaptation of the coefficients. However, as will explained below, a direct learning based approach, which may not use $f(u)$ when performing adaptation, may instead be used.

Aspects of the present disclosure relate to a deep learning architecture for implementing the DPD block 10 of FIG. 1B. DPD blocks according to example aspects of the present disclosure may therefore be referred to as a deep learning (DL) DPD blocks.

Various implementations of the technology described herein may enable the capture of the non-linearity behaviour of different types of power amplifier, and may efficiently mitigate the memory effects of the power amplifier, without mathematical modelling. By eliminating the need for mathematical modelling, the computational resources required for performing digital pre-distortion may be reduced. Various implementations of described technology leverage the design of the conventional DPD approach (that is the use of a distortion block and an adaptation block), and the power of deep learning to effectively model the PA behaviours and replace conventional DPD algorithms with deep learning cores. Furthermore, the reduced complexity of the DL DPD approach described herein is such that it may be deployed in embedded systems such as ASIC and FPGA boards.

Implementations of the described technology may provide improved linearity of base station power amplifiers, when handling higher operating frequency bands, wider bandwidths, and multiple power amplifiers use cases. For instance, implementations have been shown to provide an adjacent channel leakage ratio (ACLR) that is less than <-50 dBc, which is better than most if not all existing technologies, having the same or lower computational resource usage. In addition, implementations have been found to provide wider bandwidth linearization at higher frequencies (i.e. >>100 MHz). For instance, implementations have been found to effectively linearize for signals having a bandwidth of 200 MHz at a frequency of 3.5 GHz. Additionally, the deep learning DPD approach described herein may be usable with various different types of power amplifier and may provide a scalable solution that can be utilised with future radio products. In addition, the deep learning DPD approach described herein may also be used with dual band and multiple band transmission.

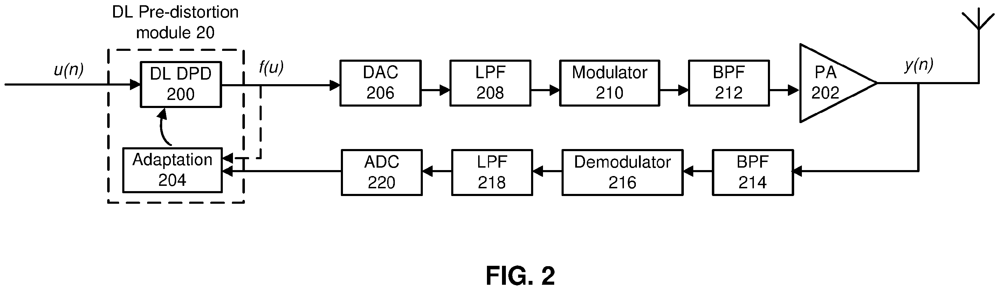

FIG. 2 illustrates an example implementation of a DL pre-distortion apparatus 20 according to the present disclosure provided within an example transmit path of a radio frequency (RF) transmission apparatus such as a base station.

The DL pre-distortion apparatus 20 is configured to receive an input signal u(n) and to pre-distort the input signal to generate a pre-distorted signal *f(u)* which is ultimately amplified by a power amplifier 202 to generate an amplified signal *y(n)*. The signals *u(n), f(u)* and *y(n)* contain both the in-phase (I) and quadrature (Q) signals.

In the illustrated example, the pre-distorted signal *f(u)* is passed to the power amplifier 202 by way of a digital-to-analogue converter 206, a low pass filter 208, a modulator 210, and a band-pass filter 212. A feedback signal representing the output *y(n)* of the power amplifier 202 is fed back to the DL pre-distortion apparatus 20, where it may be used for adjusting coefficients based on which the pre-distortion is applied to the input signal. The feedback signal may arrive at the pre-distortion apparatus by way of a band-pass filter 214, a demodulator 216, a low pass filter 218, and an analogue-to-digital converter 220.

As illustrated in the example of FIG. 2, the pre-distortion apparatus 20 may comprise a deep-learning (DL) pre-distortion block 200 and an adaptation block 204. Once trained, the DL DPD block 200 is configured to pre-distort the input signal to compensate for the distortion/non-linearity introduced by the power amplifier 202. The adaptation block 204 is configured to adjust a subset of the coefficients of the DL DPD block 200 based on the output of the amplifier *y(n),* and also the output *f(u)* of the DL DPD block 200.

## DL DPD Block Architecture(s)

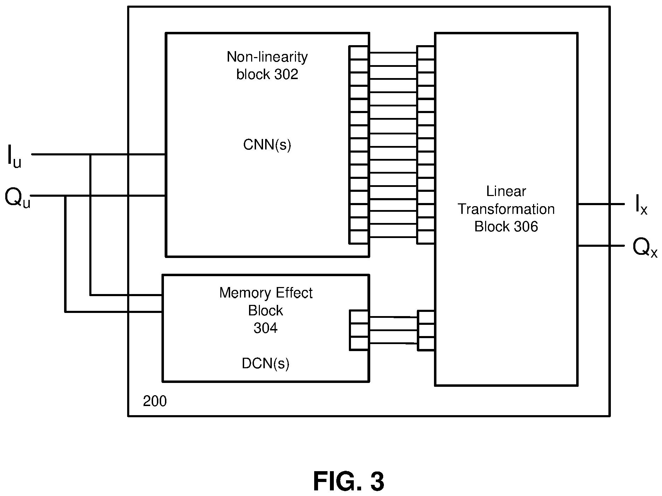

FIG. 3 is a schematic illustration of the DL DPD block 200 according to various example implementations. The DL DPD block 200 comprises a first neural network block 302 and a second neural network block 304. The first and second neural network blocks are configured to receive a digital input signal u(n) that is to be amplified by a power amplifier 202. Once trained, the first neural network block 302 may capture non-linearity of the power amplifier 202 and the second neural network block 304 may capture the memory effect.

The input signal u(n) is in the form of in-phase (I) and quadrature (Q) signals, $I_u$ and $Q_u$. The input signal may arrive at the DL DPD block 200 as a time series of matrices, with each matrix representing a time series of I and Q data (e.g. in respective columns). The matrices received may be non-overlapping. That is, a first matrix arriving at the DL DPD block may include I and Q data for times steps t=1 to t=N and a next matrix in the series may include I and Q data for times steps t=N+1 to t=M.

The first neural network block 302 includes multiple convolutional neural network layers. The first neural network block 302 processes the input signal to generate a first neural network block output. The second neural network block 304 includes at least one dilated convolutional neural network layer. The second neural network block 304 processes the input signal to generate a second neural network block output.

The DL DPD block 200 may further comprise a linear transformation block 306 which receives the first and second neural network block outputs. The linear transformation block 306 combines the first and second neural network block outputs to generate the pre-distorted signal *f(u)*, which may also be in the form of I and Q signals, $I_x$ and $Q_x$. The linear transformation block 306, which may comprise a single linear transformation layer, has plural coefficients which are used when combining the first and second neural network block outputs to generate the pre-distorted signal *f(u)*.

As will be explained below, the first neural network block 302, the second neural network block 304 and the linear transformation block 306 may be trained to mimic ideal digital pre-distortion for the power amplifier. Put another way, the first neural network block 302, the second neural network block 304 and the linear transformation block 306 may be trained so as to minimize the loss function $g(\cdot)$ between *x(n)* (the ideal distortion) and *f(u)* (as discussed above with reference to FIG. 1). Together the first neural network block 302, the second neural network block 304 and the linear transformation block 306 may be referred to as a machine-learned DPD model.

The adaptation block 204 may be configured to adapt the coefficients of the linear transformation block 306, continuously in real-time, during online operation of the DL pre-distortion apparatus 20. Specifically, the adaptation block 204 may receive data representing the amplified pre-distorted signal *y(n)* and, based on the data representing the amplified pre-distorted signal *y(n),* adapt the coefficients of the linear transformation block 306. In some implementations, such as those using an indirect learning based approach to adaptation, the adaptation block may adapt the coefficients based on the pre-distorted signal *f(u)* as well as *y(n)*. Whereas the coefficients of the linear transformation block 306 may be adapted during online operation, the coefficients of the first and second neural network blocks 302, 304, which are determined during training of the DL DPD block 200, may remain unchanged. Since the number of coefficients in the linear transformation block 306 that are adapted in real-time is significantly less than the number of coefficients in the first and second neural network blocks 302, 304, the adaptation complexity may be kept low. Furthermore, since the number of coefficients that are to be adapted in real-time is small, a relatively simple, and so computationally inexpensive, adaptation algorithm may be employed by the adaptation block 204. For instance, in some implementations, the least mean square method can be used by the adaptation block 204 when performing adaptation of the coefficients.

In the linear transformation block 306, (which may comprise a single linear transformation layer or multiple linear transformation layers) there may be one coefficient for each channel of data arriving at the block 306. The number of channels arriving at the linear transformation block 306 from the second neural network block 304 may be less than the

EP 4 320 723 B1

number of channels from the first neural network block 302. This may be because fewer channels may be required to capture the memory effect of the power amplifier than the non-linearity. The number of channels in each block may be chosen so as to allow for accurate performance while ensuring that the model size is not too large. For instance, in one specific implementation that has been evaluated by the inventors and is discussed more detail below, fifteen channels may be received from the first neural network block 302 and three channels may be received from the second neural network block 304. In such an implementation, the linear transformation block 306 may have 18 coefficients that are to be updated by the adaptation block 204.

The CNN layers used in the first neural network 302 block may be depthwise separable convolution layers. These have been shown to be more efficient than regular convolution layers, while maintaining high accuracy. The DCN layers in the second neural network block 304 may also be depthwise separable convolution layers but perform higher dilated convolution (e.g. 2, 4, 8 etc.). This allows the DCNs to have a large receptive view and so to capture the memory effect of the power amplifier.

In addition, CNNs and DCNs are less computationally expensive as compared to RNNs or LSTMs and, when used in the manner described herein, have also been found to yield better performance than RNN and LSTM-based approaches. For instance, one such RNN/LSTM-based approach was found to yield worse performance and to be more than twice as complex as the CNN/DCN-based approach described herein.

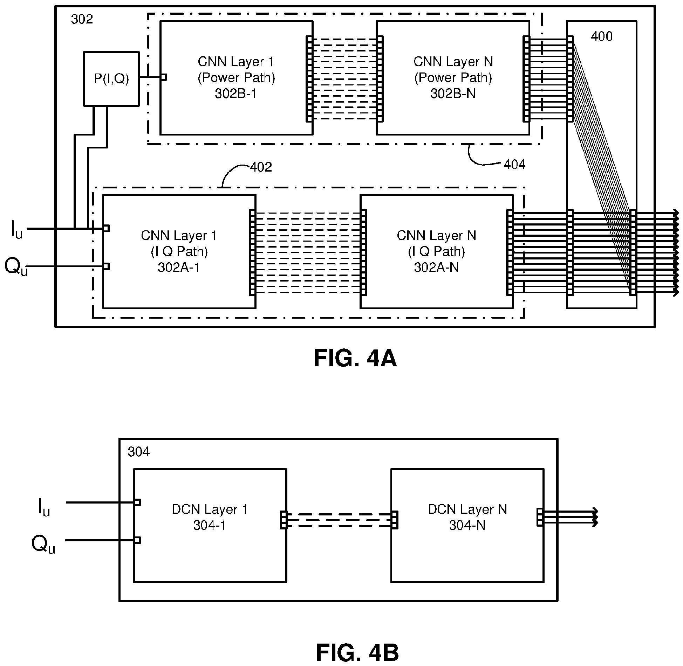

Figures 4A and 4B show a more detailed view of examples of the first and second neural network blocks 302, 304 shown in FIG. 3.

As illustrated in FIG. 4A, the first neural network block 302 may comprise a first NN processing path 402 of plural CNN layers 302A-1 to 302A-N in series and a second NN processing path 404 of plural CNN layers 302B-1 to 302B-N in series. The first NN processing path 402 may receive the I and Q input data, $I_u$ and $Q_u$. The second neural network path 404 may receive second input data representing power values, $P_u$, of the $I_u$ and $Q_u$ input data. The power values of the I and Q input data may be determined based on the input data according to the formula: $P = I^2 + Q^2$. By using separate NN processing paths 402, 404 for the I and Q input signals and the power associated with these signals, information loss may be avoided which may improve the linearity of the amplification process and the power efficiency of the transmitter (e.g. a BTS).

The first neural network processing path 402 may process the I and Q input data by passing it through the series of CNN layers 302A-1 to 302A-N to generate a first neural network processing path output. The second neural network processing path 404 may process the second input data representing the power values $P_u$ of the I and Q input data by passing it through a series of plural CNN layers 302B-1 to 302B-N to generate a second neural network processing path output. In some examples, the first and second processing paths 402, 404 may include the same number of CNN layers. The respective input data may be processed by the CNN layers in the first and second processing paths such that the input to a particular CNN layer is, or is derived from, the output of the preceding CNN layer (if there is one).

The first neural network processing path output and the second neural network processing path output may be combined by a combination function 400 to generate the first neural network block output. In some examples, the combination function 400 may be a multiplication function. As mentioned above, the first neural network block output is passed to the linear transformation block 306, which combines the first neural network block output with the second neural network block output.

As illustrated in FIG. 4B, the second neural network block 304 may comprise a processing path of one or more DCN layers 304-1 to 304-N. The second neural network block 304 receives the I and Q input data $I_u$, $Q_u$ and processes the I and Q input data by passing it through a series of one or more DCN layers to generate the second neural network block output. As mentioned previously, the use of DCN layers allows the long term memory effect of the PA to be modelled, while exploiting the efficiencies of convolutional layers as opposed to, for instance, RNNs or LSTMs.

In one specific implementation that has been evaluated by the inventors, the first and second processing paths of the first neural network block 302 each include four CNN layers and the second neural network block 304 includes eight DCN layers. However, the number of CNN/DCN layers in each of the layers/paths may be more or less than this example and may, in fact, be scalable for future radio products.

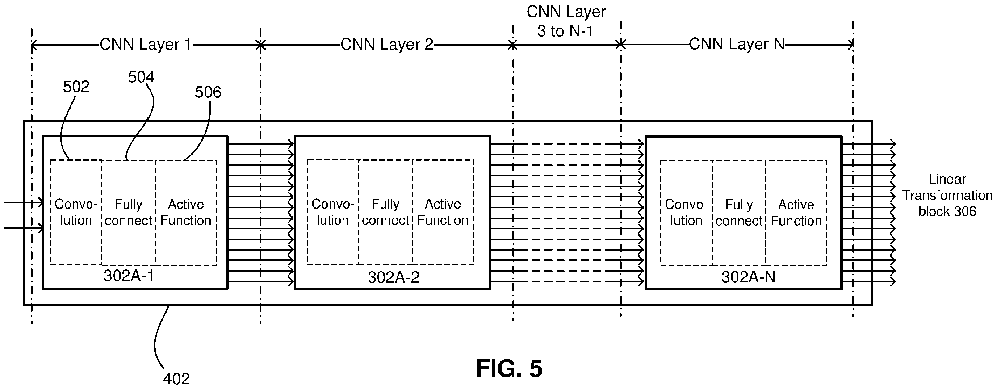

FIG. 5 is a more detailed view of an example configuration of the first NN processing path 402 depicted in FIG. 4. As can be seen in FIG. 5, one, more than one, or all of the CNN layers 302A-1 to 302A-N of the path may include a convolution sub-layer 502, a fully connected sub-layer 504 and an activation function 506. The convolution sub-layer 502 may be in the form of finite infinite response (FIR) filters. The combination of a convolution sub-layer and a fully connected sub-layer is often referred to referred to as a separated CNN structure, or a depthwise separable convolution. The FIR filters of the convolution sub-layer may be performed depthwise convolution and the subsequent fully connected layer may perform pointwise convolution. Depthwise separable convolution has shown great efficiency over regular convolution, while maintaining high accuracy.

The activation function 506 may be the Hyperbolic Tangent (Tanh) function. Employing the Tanh activation function may significantly reduce the number of CNN layers required. In addition, it may precisely capture the non-linearity, and can be easily implemented in FPGAs using a look-up-table method (for instance, using odd-order polynomials).

The first neural network processing path 402 may be formed by cascading multiple CNN layers, such that the data is passed successively through the CNN layers in the path. Although not shown, a batch normalization layer may be included after each CNN layer to improve stability of the system. The length of the processing path can be increased or decreased, depending on the complexity of the required deep learning model.

The second neural network processing path 404 may have a similar (or the same structure) as the first neural network processing path 402 described with reference to FIG. 5. That is, in certain implementations, the second processing path 404 may be formed of multiple CNN layers, themselves formed of a convolution sub-layer 502 (e.g. FIR filters) a fully connected sub-layer 504 and an activation function 506 (e.g. the tanh function). In addition, batch normalization layers may be provided between the layers.

In addition, the processing path of the second neural network block 304 may take a similar form to that depicted and described with reference to FIG. 5. That is, in certain implementations, the processing path of the second neural network block 304 may be formed of multiple DCN layers 304-1 to 304-N, themselves formed of a convolution sub-layer 502 (e.g. FIR filters), a fully connected sub-layer 504 and an activation function 506 (e.g. the tanh function). In addition, batch normalization layers may be provided between the layers. The main difference, however, between the processing path of the second neural network block 304 and the processing paths of the first block 302 is that the DCN layers 304-1 to 304-N have a convolution dilation size of greater than one.

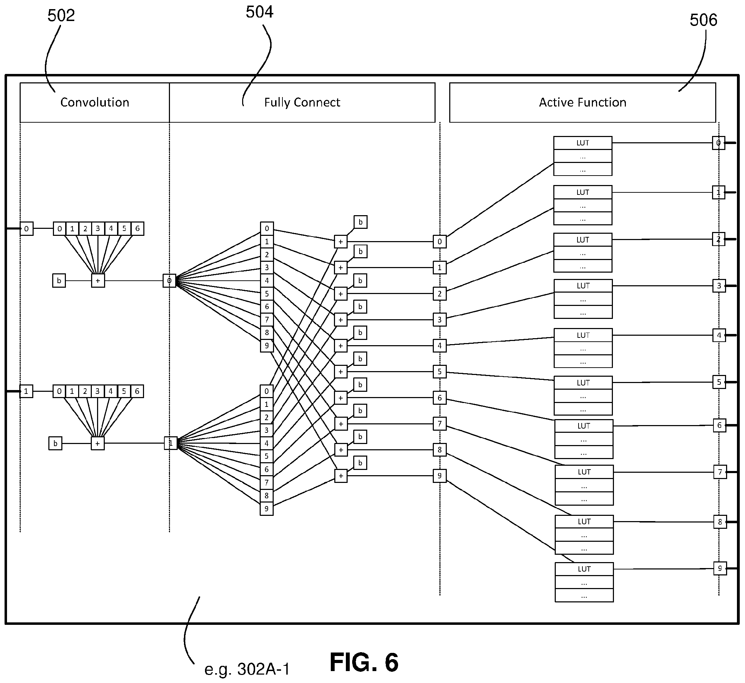

FIG. 6 is a more detailed view of a CNN (or DCN) layer of the type which may be employed in the first and second neural network processing blocks 302, 304. The specific example shown has two input channels and ten outputs. In the convolution sub-layer 502, convolution with coefficients may be applied to every input channel and after that a bias may be added. Each input channel may be handled individually with different convolution coefficients and bias setting. In the example shown, there are seven coefficients and one bias for each channel. In the fully connected layer 504, each of the input channels may be extended to multiple channels with different coefficients and bias. In the activation function sub-layer 506, the activation function is applied to every channel. A lookup table based approach may be employed for applying the activation function. Batch normalization may be applied to the output of each channel.

Training of DL DPD Block

The DL DPD block 200 may be trained using supervised learning. Such learning makes use of a target against which to compare the output of the DL DPD block 200 during training. The training target may be the ideal digital pre-distortion for the particular power amplifier. As such, once the model is trained, the DL DPD block 200 may mimic, or closely reflect, the performance of ideal digital pre-distortion for the particular power amplifier.

*Step 1: Obtaining data representing ideal DPD performance.*

A test environment may be set up to obtain the data representing the ideal digital pre-distortion. The test environment may include a signal generator for generating an input signal $u_T(n)$. The input signal $u_T(n)$ may comprise a cyclical wideband radio signal. A computing system may receive the input signal and perform digital pre-distortion to generate an output signal $x_T(n)$. The output signal $x_T(n)$ is then passed through the power amplifier for which the ideal DPD is being obtained. The output of the power amplifier $y_T(n)$ is then provided to the computing system. The pre-distortion applied by the computing system may be optimised based on the input signal $u_T(n)$ and the output of the power amplifier $y_T(n)$. Specifically, the pre-distortion applied by the computing system may be optimised over multiple iterations, sample by sample, by minimising, in the time domain, the error between the input signal $u_T(n)$ and the output of the power amplifier $y_T(n)$. Optimisation of the digital pre-distortion may continue until the output $x_T(n)$ of the digital pre-distortion is stable. Once optimisation has been completed, the input signal $u_T(n)$ and the output of the ideal pre-distortion $x_T(n)$ are captured for use in training the DL DPD block 200.

*Step 2: Training the DL DPD block.*

Prior to training, the model of the DL DPD block 200 (e.g. the first NN block 302, the second NN block 304 and the linear transformation block 306 as described with reference to and depicted in Figures 3 to 6) is initialised. This may include initializing hyperparameters such as the learning rate, decay rate, and weight initialization for the various constituent neural networks.

The loss function used for training the model may be, but is not limited to, mean squared error (MSE). The model may be optimised using a stochastic gradient descent algorithm such as, but not limited to Adam optimization algorithm. The training may be performed using a machine learning software such as but not limited to PyTorch.

The model may be trained over a number of epochs using the input training signal $u_T(n)$ and the ideal pre-distortion signal $x_T(n)$ captured in step 1 above. When the training is sufficiently stable, the training is stopped. The training may be considered sufficiently stable when an error, e.g. the normalised mean square error (NMSE), between the output of the model $f(u_T)$ and the ideal pre-distortion $x_T(n)$ is at an acceptable level. In some example implementations, an acceptable NMSE may be approximately -45 dB.

Prior to use, e.g. in an FPGA or an ASIC, the trained model may first be verified, for instance using the input training signal $u_T(n)$ and the ideal pre-distortion signal $x_T(n)$, to ensure that it performs effectively. Once the trained model has been verified, it may be extracted and converted. Subsequently, the coefficients defining the model (i.e. the coefficients of the first NN block 302, the second NN block 304 and the linear transformation block 306) may be loaded into a product (e.g. an FPGA or ASIC board) for online use (the online phase).

As will be appreciated, a new DL DPD model may be trained for each different type of power amplifier, which will have its own distortion characteristics. However, the DL DPD block architecture described above with reference to Figures 3 to 6 may be used with many different types of power amplifier.

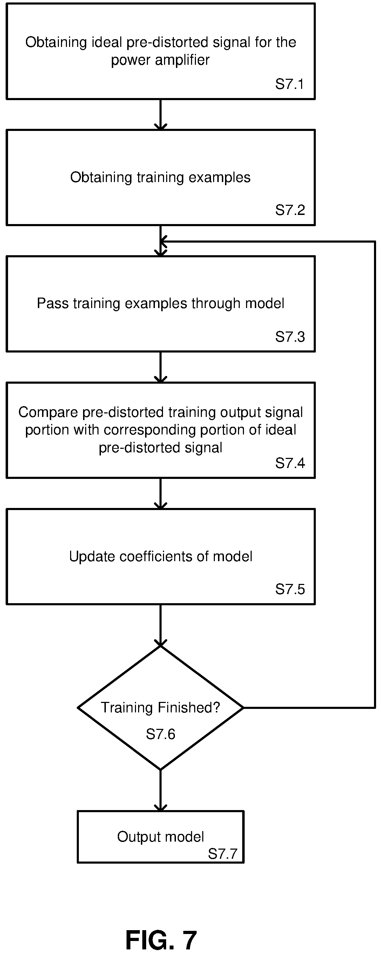

FIG. 7 is a flow chart illustrating examples of various operations which may be performed in connection with training the pre-distortion apparatus 20.

In S7.1, an ideal pre-distorted radio frequency signal may be obtained. This may comprise performing multiple iterations of: processing a cyclical signal (e.g. a wideband radio signal) using a pre-distortion algorithm to generate a pre-distorted cyclical signal, passing the pre-distorted cyclical signal through a power amplifier to generate an amplified cyclical signal, comparing the amplified cyclical signal with the cyclical signal, and optimising the pre-distortion algorithm based on the comparison.

In S7.2, training examples may be obtained from the cyclical signal and the ideal pre-distorted signal. Specifically, training examples may comprise portions of the cyclical signal and corresponding portions of the ideal pre-distorted signal. The ideal pre-distorted signal may be obtained by passing the cyclical signal through the optimised pre-distortion algorithm.

In S7.3, portions of the cyclical signal are passed through the model of the DL-DPD block 200. More specifically, portions of the cyclical signal are passed through the first neural network block 302 and the second neural network block 304. Outputs of the first neural network block 302 and the second neural network block 304 are then processed using the linear transformation block 306 to generate pre-distorted training output signal portions.

In S7.4, the pre-distorted training output signal portions are compared with the corresponding portions of the ideal pre-distorted signal.

In S7.5, the coefficients of the model (i.e. the coefficients of the first neural network block 302, the second neural network block 304, and the linear transformation block 306) are updated based on the comparison.

In S7.6, it is determined whether training has finished. This may be determined based on the accuracy of the model and/or the number of training epochs performed. If it is determined that training has finished, the model is output in S7.7 for verification and/or online use. If it is determined that training has not finished, further training is performed and so the method returns to S7.3.

Online Phase

Once the model has been trained, the DL-DPD apparatus 20 may be used to pre-distort incoming signals that are to be amplified by a power amplifier for which the DL-DPD block 200 has been trained.

As mentioned above, during the online phase, an adaptation block 204 may perform adaptation of the coefficients of the DL-DPD block 200 in order to adapt the pre-distortion applied by the DL DPD block. Such adaptation may be performed as the input $uo(n)$ to the DL DPD block 200 changes to ensure that the pre-distortion continues to be effective. The adaptation may be performed using a least mean square method.

Two common methods for performing adaptation are indirect learning and direct learning. FIG. 1B shows an indirect learning architecture, where the input $f(u)$ and output/feedback y(n) of the PA 12 are used. An example of an indirect learning approach to adaptation, which may be performed by the adaptation block 204 is as follows:

The power amplifier gain is assumed to be G, such that y(n) = G*x(n). Let us denote $\tilde{y} = y/G$. The DL DPD block 200 produces a signal $x =: f(u) = U_n C,$ where C represents the coefficients in the linear transformation block. The adaptation block 204 may use a post-distorter to model $\tilde{y} = U_n \, y/G$. Ideally $\tilde{y} = x$, which gives an error, $e(n) =: \tilde{y} - U_n C = U_n \, y/G - U_n C = 0$. A least mean square (LMS) method may be leveraged to perform the adaptation so that the error $|e(n)|^2$ is minimized. As such, an equation used for updating the coefficients of the linear transformation block may be expressed as:

$$C(n) = C(n-1) - \frac{1}{2}\mu\frac{\partial|e(n)|^2}{\partial C(n)} = C(n-1) + \mu e(n)\frac{y}{G},$$

where μ is the step-size parameter of the LMS method.

In a direct learning-based approach, the adaptation may be performed on the basis of PA output *y(n)*, by minimizing the error between $G_o u(n)$ (that is, the ideally amplified input signal, where $G_o$ is the linear gain of the amplifier) and the PA output *y(n)*.

As will be appreciated, adaptation may be performed in any appropriate manner using either indirect or direct learning. For instance, adaptation may be performed as described in Ding, L., Ma, Z., Morgan, D.R., Zierdt, M. and Pastalan, J., 2006. A least-squares/Newton method for digital predistortion of wideband signals. IEEE Transactions on communications, 54(5), pp.833-840 or Le Due, H., Feuvrie, B., Pastore, M. or Wang, Y., 2018. An adaptive cascaded ILA- and DLA-based digital predistorter for linearizing an RF power amplifier. IEEE Transactions on Circuits and Systems I: Regular Papers, 66(3), pp.1031-1041.

One of benefits that may be provided by various implementations of the disclosed technology is that only a subset of the coefficients of the DL DPD block may be adapted by the adaptation block 204 in the online phase, whilst still providing good DPD performance. Specifically, only the coefficients of the linear transformation block 306 may be adapted in the online phase, with the other coefficients, i.e. those of the first and second NN blocks 302, 304, remaining constant. This may make the adaptation process during the online phase relatively computationally simple.

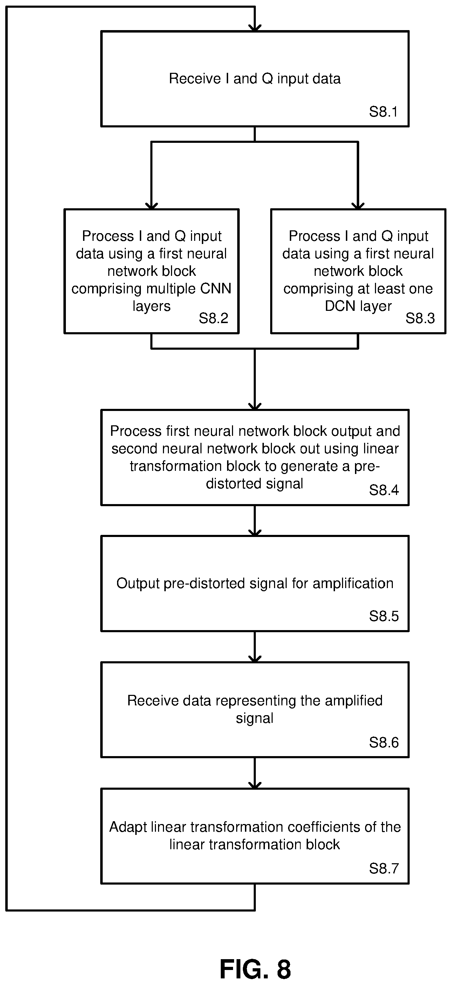

FIG. 8 is a flow chart illustrating examples of various operations which may be performed by one or more processors associated with the pre-distortion apparatus 20 in the online phase.

In S8.1, input data representing I and Q signals of an input radio frequency signal that is to be amplified by a power amplifier is received.

In S8.2, the received input data may be processed, using the first neural network block 302 of the machine learned model of the pre-distortion block 200, to generate a first neural network block output. As described above, the first neural network block 302 comprises plural CNN layers.

Processing the input data using the first neural network block 302 may include processing the input data by passing the input data through the first neural network processing path 402 of the first neural network block 302 to generate a first neural network processing path output. It may also include determining, based on the input data, second input data representing power values of the I and Q signals of the input data and processing the second input data by passing the second input data through a second neural network processing path 404 of the first neural network block 302 to generate a second neural network processing path output. The first neural network processing path output and the second neural network processing path output may then be combined, for instance using a multiplication function to generate the first neural network block output.

In S8.3, the received input data may be processed, using the second neural network block 304 of the machine learned model of the pre-distortion block 200, to generate a second neural network block output. As described above, the second neural network block 304 comprises at least one DCN layer.

As will be appreciated operations S8.2 and S8.3 may be performed concurrently.

In S8.4, the first neural network block output and the second neural network block output are processed using the linear transformation block 306 to generate a pre-distorted radio frequency signal for amplification by the power amplifier. In some examples, a clock delay adjustment may applied before combining the outputs of the first and second neural network blocks 302, 304 at the linear transformation block.

In S8.5, the pre-distorted signal may be output for amplification by the power amplifier.

In S8.6, data representing the amplified signal, i.e. the output of the power amplifier, may be received.

In S8.7, the linear transformation coefficients of the linear transformation block may be adapted based on the pre-distorted signal and the data representing the amplified signal. The coefficients of the first and second neural network blocks may not be adapted during the adaptation process.

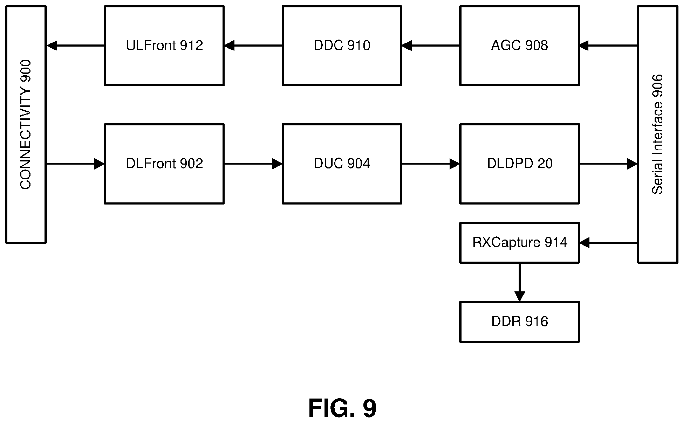

FIG. 9 is an illustration of various functions including the DL DPD apparatus 20, which may be implemented on a board such as an FPGA or ASIC in a BTS.

Data may be received at a connectivity interface 900 and processed in succession by a down link front end 902 and a digital upconverter 904. The DL-DPD 20 apparatus may receive the output of the digital upconverter 904. The output of the DL-DPD 20, which is the pre-distorted signal, may be output to a serial interface 906 from where it may be passed for amplification by a power amplifier.

Signals arriving from the serial interface 906 may first be processed by automatic gain control 908, and may be subsequently processed by a digital down converter 910 and then an uplink front end 912 before being passed to the connectivity interface 900.

The functions may additionally include an RXCapture function 914 which receives data/signals from the serial interface 906 and a double data rate function 916. The RXCapture function 914 may be configured to capture the received signal and resample the signal to produce a double data rate signal.

Specific Example Implementation

The inventors have evaluated a number of specific implementations. One such specific implementation is as follows:

- Number of CNN layers in each of the first and second processing paths 402, 404 = 4;
- Number of channels between CNN layers of the first and second processing paths 402, 404 = 15;
- Number of DCN layers in the second NN block 304 = 8;
- Number of channels between DCN layers of the second NN block 304 = 3;
- Number of time steps in the input matrices = $2^{17}$;
- Bit width of input signals = 18 bits (1.0.17);
- Coefficients in linear transformation layer = 18;
- Total number of coefficients (including coefficients in linear transformation layer) = 2296
- DL DPD initialization parameters used for initialising the model prior to training:

  • Optimization algorithm: Adam optimizer (see e.g. Kingma, D.P. and Ba, J., 2015. Adam: A method for stochastic optimization. In Proceedings of the 3rd International Conference on Learning Representations.)
  • Initial learning rate: 0.01
  • Decay learning rate after 10K epochs: 0.8
  • Loss function: Mean squared error
  • Weight initialization: Kaiming's method (see e.g. He, K., Zhang, X., Ren, S. and Sun, J., 2015. Delving deep into rectifiers: Surpassing human-level performance on ImageNet classification. In Proceedings of the IEEE international conference on computer vision (pp. 1026-1034)) [3]
  • Bias initialization: 0
  • Training epochs: 100K

Performance

The DL-DPD approach/architecture described herein has been shown to provide a surprising performance. For example, in an experiment involving transmission of a single wideband signal with 10xLTE20 carriers (total of 200 MHz bandwidth), the Adjacent Channel Leakage Ratio (ACLR) has been found to be approximately 51.44 dBc, which is a very good performance for any digital front end DPD sub-system. In addition, the DL-DPD architecture which achieved this performance was implemented in FPGA board utilising only 2195 digital signal processors. Such a number of DSPs is comparable to that used by other DPD solutions.

In addition, other test cases with different PAs, power level and signal bandwidths have been carried out and also yielded good performance. For instance, in a dual band test case in which there are three LTE20 carrier signals in each band (band 1 and band 3) generated at a transmitting power of 38 dBm, the ACLR has been verified as approximately -56 dB for both bands 1 and 3. The described approach has also been found to be effective in time division duplex (TDD) implementations, for which DPD is usually very difficult.

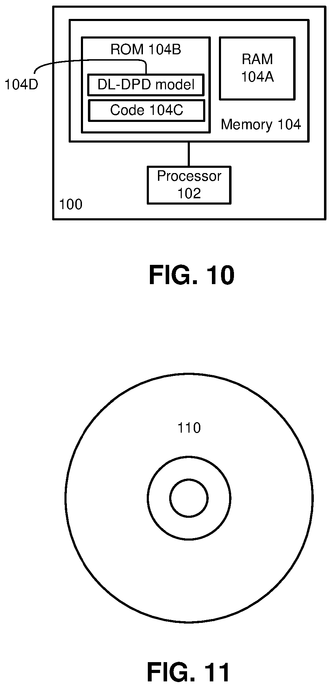

FIG. 10 shows an example apparatus 100 that may comprise the DL-DPD apparatus 20 described herein or apparatus for training the DL-DPD apparatus 20. In examples in which the apparatus 100 comprises the DL-DPD apparatus 20, the apparatus may be or may be part of an FPGA or ASIC.

The apparatus 100 may comprise at least one processor 102 and at least one memory 104 directly or closely connected or coupled to the processor. The memory 104 may comprise at least one random access memory (RAM) 104A and at least one read-only memory (ROM) 104B. Computer program code 104C may be stored in the ROM 104B. In examples in which the apparatus 100 comprises the DL-DPD apparatus 20, the data representing the DL-DPD model 104D may be stored in the ROM 104B. The apparatus 100 may be connected to a transmitter path and/or a receiver path in order to obtain respective signals or data. The apparatus may be connected with a user interface (UI) for instructing the apparatus and/or for outputting data. The at least one processor 102 with the at least one memory 104 and the computer program code 104C may be arranged to cause the apparatus to at least perform methods described herein.

The processor 102 may be a microprocessor, plural microprocessors, a microcontroller, or plural microcontrollers. The memory 104 may take any suitable form.

FIG. 11 shows a non-transitory media 110 according to some embodiments. The non-transitory media 110 is a computer readable storage medium. It may be e.g. a CD, a DVD, a USB stick, a blue ray disk, etc. The non-transitory media 110 may store computer program code causing an apparatus to perform operations described above when executed by a processor such as processor 102 of FIG 10. The non-transitory media 110 may also store data representing the DL-DPD model 104D of DL DPD block 200, which may be generated by means of performing the operations described above with reference to FIG. 7.

Any mentioned apparatus and/or other features of particular mentioned apparatus may be provided by apparatus arranged such that they become configured to carry out the desired operations only when enabled, e.g. switched on, or the like. In such cases, they may not necessarily have the appropriate software loaded into the active memory in the non-enabled (e.g. switched off state) and only load the appropriate software in the enabled (e.g. on state). The apparatus may comprise hardware circuitry and/or firmware. The apparatus may comprise software loaded onto memory. Such software/computer programs may be recorded on the same memory/processor/functional units and/or on one or more memories/processors/ functional units.

In some examples, a particular mentioned apparatus may be pre-programmed with the appropriate software to carry out desired operations, and wherein the appropriate software can be enabled for use by a user downloading a "key", for example, to unlock/enable the software and its associated functionality. Advantages associated with such examples can include a reduced requirement to download data when further functionality is required for a device, and this can be useful in examples where a device is perceived to have sufficient capacity to store such pre-programmed software for functionality that may not be enabled by a user.

Any mentioned apparatus/circuitry/elements/processor may have other functions in addition to the mentioned functions, and that these functions may be performed by the same apparatus/circuitry/elements/processor. One or more disclosed aspects may encompass the electronic distribution of associated computer programs and computer programs (which may be source/transport encoded) recorded on an appropriate carrier (e.g. memory, signal).

Any "computer" described herein can comprise a collection of one or more individual processors/processing elements that may or may not be located on the same circuit board, or the same region/position of a circuit board or even the same device. In some examples one or more of any mentioned processors may be distributed over a plurality of devices. The same or different processor/processing elements may perform one or more functions described herein.

The term "signalling" may refer to one or more signals transmitted as a series of transmitted and/or received electrical/optical signals. The series of signals may comprise one, two, three, four or even more individual signal components or distinct signals to make up said signalling. Some or all of these individual signals may be transmitted/received by wireless or wired communication simultaneously, in sequence, and/or such that they temporally overlap one another.

With reference to any discussion of any mentioned computer and/or processor and memory (e.g. including ROM, CD-ROM etc.), these may comprise a computer processor, Application Specific Integrated Circuit (ASIC), field-programmable gate array (FPGA), and/or other hardware components that have been programmed in such a way to carry out the inventive function.

## Claims

1. An apparatus comprising means for:
   pre-distorting an input signal, that is to be amplified by a power amplifier (202), by:

   > processing (S8.2), by a first neural network block (302) comprising multiple convolutional neural network layers, input data representing in-phase, I, and quadrature, Q, signals of the input signal to generate a first neural network block output;
   > processing (S8.3), by a second neural network block (304) comprising at least one dilated convolutional neural network layer, the input data to generate a second neural network block output; and
   > combining (S8.4), using a linear transformation block (306) having plural linear transformation coefficients, the first neural network block output and the second neural network block output to generate a pre-distorted signal for amplification by the power amplifier, wherein amplification of the pre-distorted signal by the power amplifier produces an amplified signal,

   wherein the means are further configured to:

   > receive (S8.6) data representing the amplified signal; and
   > based on the data representing the amplified signal, adapt (S8.7) the linear transformation coefficients of the linear transformation block.

2. The apparatus of claim 1, wherein the processing, by the first neural network block, the input data to generate the first neural network block output comprises:

   > processing, by a first neural network processing path of the first neural network block, the input data to generate a first neural network processing path output;

determining, based on the input data, second input data representing power values of the I and Q signals of the input data;

processing, by a second neural network processing path of the first neural network block, the second input data to generate a second neural network processing path output; and

combining the first neural network processing path output and the second neural network processing path output to generate the first neural network block output.

3. The apparatus of claim 2, wherein the first neural network processing path output and the second neural network processing path output are combined by multiplication.

4. The apparatus of claim 2 or claim 3, wherein the first neural network processing path comprises one or more convolutional neural network layers and the second neural network processing path comprises one or more convolutional neural network layers.

5. The apparatus of claim 1, wherein coefficients of the first and second neural network processing blocks are not adapted.

6. The apparatus of claim 1 or claim 5, wherein the linear transformation coefficients of the linear transformation block are adapted using a least mean square method.

7. The apparatus of any of claims 1, 5 or 6, wherein coefficients of the first neural network block and the second neural network block and initial linear transformation coefficients of the linear transformation block were determined during end-to-end training.

8. The apparatus of any of claims 1, 5, 6 or 7, wherein the first neural network block, the second neural network block and the linear transformation block were trained end to end to mimic ideal digital pre-distortion for the power amplifier.

9. The apparatus of claim 8, wherein the first neural network block, the second neural network block and the linear transformation block were trained by:

passing an input training data sample, representing I and Q signals of a training input signal portion, through the first neural network block;

passing the input training data sample through the second neural network block;

processing outputs of the first neural network block and the second neural network block using the linear transformation block to generate a pre-distorted training output signal portion;

comparing the pre-distorted training output signal portion with an ideal pre-distorted signal portion for the power amplifier; and

updating coefficients of one or more of the first neural network block, the second neural network block, and the linear transformation block based on the comparison.

10. The apparatus of claim 9, wherein the ideal pre-distorted signal portion was obtained by performing multiple iterations of:

processing a cyclical signal using a pre-distortion algorithm to generate a pre-distorted cyclical signal;

passing the pre-distorted cyclical signal through a power amplifier to generate an amplified cyclical signal;

comparing the amplified cyclical signal with the cyclical signal;

optimising the pre-distortion algorithm based on the comparison.

11. The apparatus of claim 10, wherein the training input signal portion is a portion of the cyclical signal and the ideal pre-distorted output signal portion is the output of the optimised pre-distortion algorithm resulting from processing the portion of the cyclical signal.

12. The apparatus of any preceding claim, wherein the activation function for at least some of the convolutional neural network layers is a tanh activation function.

13. The apparatus of any preceding claim, wherein at least some of the convolutional neural network layers apply a depthwise separable convolution.

14. The apparatus of any preceding claim, wherein the apparatus is an application specific integrated circuit or a field programmable gate array.

15. A non-transitory memory medium storing computer readable code and a machine-learned model, the machine-learned model comprising:

a first neural network block (302) comprising multiple convolutional neural network layers;
a second neural network block (304) comprising at least one dilated convolutional neural network layer; and
a linear transformation block (306) having plural linear transformation coefficients,

wherein the computer readable code, when executed, causes the at least one processor to:

receive (S8.1) input data representing in-phase, I, and quadrature, Q, signals of an input signal that is to be amplified by a power amplifier (202);
process (S8.2) the received input data using the first neural network block of the machine learned model to generate a first neural network block output;
process (S8.3) the received input data using the second neural network block of the machine learned model to generate a second neural network block output;
combine(S8.4), using the linear transformation block, the first neural network block output and the second neural network block output to generate a pre-distorted signal for amplification by the power amplifier, wherein amplification of the pre-distorted signal by the power amplifier produces an amplified signal;
receive (S8.6) data representing the amplified signal; and
based on the data representing the amplified signal, adapt (S8.7) the linear transformation coefficients of the linear transformation block.

## Patentansprüche

1. Vorrichtung, die Mittel für Folgendes umfasst:
Vorverzerren eines Eingangssignals, das durch Folgendes von einem Leistungsverstärker (202) zu verstärken ist:

Verarbeiten (S8.2) von Eingangsdaten, die Inphasen(I)- und Quadratur(Q)-Signale des Eingangssignals repräsentieren, durch einen ersten neuronalen Netzwerkblock (302), der mehrere neuronale Faltungsnetzwerkschichten umfasst, um eine erste neuronale Netzwerkblockausgabe zu erzeugen;
Verarbeiten (S8.3) der Eingangsdaten durch einen zweiten neuronalen Netzwerkblock (304), der mindestens eine erweiterte neuronale Faltungsnetzwerkschicht umfasst, um eine zweite neuronale Netzwerkblockausgabe zu erzeugen; und
Kombinieren (S8.4) der ersten neuronalen Netzwerkblockausgabe und der zweiten neuronalen Netzwerkblockausgabe unter Verwendung eines linearen Transformationsblocks (306), der mehrere lineare Transformationskoeffizienten aufweist, um ein vorverzerrtes Signal zur Verstärkung durch einen Leistungsverstärker zu erzeugen, wobei eine Verstärkung des vorverzerrten Signals durch den Leistungsverstärker ein verstärktes Signal produziert,
wobei die Mittel ferner zu Folgendem ausgelegt sind:

Empfangen (S8.6) von Daten, die das verstärkte Signal repräsentieren; und
Anpassen (S8.7) der linearen Transformationskoeffizienten des linearen Transformationsblocks auf Basis der Daten, die das verstärkte Signal repräsentieren.

2. Vorrichtung nach Anspruch 1, wobei das Verarbeiten der Eingangsdaten durch den ersten neuronalen Netzwerkblock, um eine erste neuronale Netzwerkblockausgabe zu erzeugen, Folgendes umfasst:

Verarbeiten der Eingangsdaten durch einen ersten neuronalen Netzwerkverarbeitungspfad des ersten neuronalen Netzwerkblocks, um eine erste neuronale Netzwerkverarbeitungspfadausgabe zu erzeugen;
Bestimmen der zweiten Eingangsdaten, die Leistungswerte der I- und Q-Signale der Eingangsdaten repräsentieren, auf Basis der Eingangsdaten;
Verarbeiten der zweiten Eingangsdaten durch einen zweiten neuronalen Netzwerkverarbeitungspfad des ersten neuronalen Netzwerkblocks, um eine zweite neuronale Netzwerkverarbeitungspfadausgabe zu erzeugen; und
Kombinieren der ersten neuronalen Netzwerkverarbeitungspfadausgabe und der zweiten neuronalen Netzwerkverarbeitungspfadausgabe, um die erste neuronale Netzwerkblockausgabe zu erzeugen.

3. Vorrichtung nach Anspruch 2, wobei die erste neuronale Netzwerkverarbeitungspfadausgabe und die zweite neuronale Netzwerkverarbeitungspfadausgabe durch Multiplikation kombiniert werden.

4. Vorrichtung nach Anspruch 2 oder Anspruch 3, wobei der erste neuronale Netzwerkverarbeitungspfad eine oder mehrere neuronale Faltungsnetzwerkschichten umfasst und der zweite neuronale Netzwerkverarbeitungspfad eine oder mehrere neuronale Faltungsnetzwerkschichten umfasst.

5. Vorrichtung nach Anspruch 1, wobei Koeffizienten des ersten und des zweiten neuronalen Netzwerkverarbeitungsblocks nicht angepasst sind.

6. Vorrichtung nach Anspruch 1 oder Anspruch 5, wobei die linearen Transformationskoeffizienten des linearen Transformationsblocks unter Verwendung eines Verfahrens der kleinsten mittleren Quadrate angepasst sind.

7. Vorrichtung nach einem der Ansprüche 1, 5 oder 6, wobei Koeffizienten des ersten neuronalen Netzwerkblocks und des zweiten neuronalen Netzwerkblocks und anfängliche lineare Transformationskoeffizienten des linearen Transformationsblocks während eines Ende-zu-Ende-Trainings bestimmt wurden.

8. Vorrichtung nach einem der Ansprüche 1, 5, 6 oder 7, wobei der erste neuronale Netzwerkblock, der zweite neuronale Netzwerkblock und der lineare Transformationsblock Ende-zu-Ende trainiert wurden, um eine ideale digitale Vorverzerrung für den Leistungsverstärker nachzuahmen.

9. Vorrichtung nach Anspruch 8, wobei der erste neuronale Netzwerkblock, der zweite neuronale Netzwerkblock und der lineare Transformationsblock durch Folgendes trainiert wurden:

Leiten eines Eingangsdatentrainingsmusters, das I- und Q-Signale eines Trainingseingangssignalabschnitts repräsentiert, durch den ersten neuronalen Netzwerkblock;
Leiten des Eingangsdatentrainingsmusters durch den zweiten neuronalen Netzwerkblock;
Verarbeiten von Ausgaben des ersten neuronalen Netzwerkblocks und des zweiten neuronalen Netzwerkblocks unter Verwendung des linearen Transformationsblocks, um einen vorverzerrten Trainingsausgabesignalabschnitt zu erzeugen;
Vergleichen des vorverzerrten Trainingsausgabesignalabschnitts mit einem idealen vorverzerrten Signalabschnitt für den Leistungsverstärker; und
Aktualisieren von Koeffizienten von einem oder mehreren des ersten neuronalen Netzwerkblocks, des zweiten neuronalen Netzwerkblocks und des linearen Transformationsblocks auf Basis des Vergleichs.

10. Vorrichtung nach Anspruch 9, wobei der ideale vorverzerrte Signalabschnitt durch Durchführen von mehreren Wiederholungen von Folgendem erhalten wurde:

Verarbeiten eines zyklischen Signals unter Verwendung eines Vorverzerrungsalgorithmus, um ein vorverzerrtes zyklisches Signal zu erzeugen;
Leiten des vorverzerrten zyklischen Signals durch einen Leistungsverstärker, um ein verstärktes zyklisches Signal zu erzeugen;
Vergleichen des verstärkten zyklischen Signals mit dem zyklischen Signal;
Optimieren des Vorverzerrungsalgorithmus auf Basis des Vergleichs.

11. Vorrichtung nach Anspruch 10, wobei der Trainingseingangssignalabschnitt ein Abschnitt des zyklischen Signals ist und der ideale vorverzerrte Ausgangssignalabschnitt die Ausgabe des optimierten Vorverzerrungsalgorithmus ist, die aus dem Verarbeiten des Abschnitts des zyklischen Signals resultiert.

12. Vorrichtung nach einem der vorhergehenden Ansprüche, wobei die Aktivierungsfunktion für mindestens einige der neuronalen Faltungsnetzwerkschichten eine tanh-Aktivierungsfunktion ist.

13. Vorrichtung nach einem der vorhergehenden Ansprüche, wobei mindestens einige der neuronalen Faltungsnetzwerkschichten eine in der Tiefe trennbare Faltung anwenden.

14. Vorrichtung nach einem der vorhergehenden Ansprüche, wobei die Vorrichtung eine anwendungsspezifische integrierte Schaltung oder ein feldprogrammierbares Gatearray ist.

15. Nichttransitorisches Speichermedium, in dem ein computerlesbarer Code und ein Maschinenlernmodell gespeichert sind, wobei das Maschinenlernmodell Folgendes umfasst:

einen ersten neuronalen Netzwerkblock (302), der mehrere neuronale Faltungsnetzwerkschichten umfasst;
einen zweiten neuronalen Netzwerkblock (304), der mindestens eine erweiterte neuronale Faltungsnetzwerkschicht umfasst; und
einen linearen Transformationsblock (306), der mehrere lineare Transformationskoeffizienten aufweist,
wobei der computerlesbare Code, wenn er ausgeführt wird, den mindestens einen Prozessor zu Folgendem veranlasst:

Empfangen (S8.1) von Eingangsdaten, die Inphasen(I)- und Quadratur(Q)-Signale eines Eingangssignals repräsentieren, das von einem Leistungsverstärker (202) zu verstärken ist;
Verarbeiten (S8.2) der empfangenen Eingangsdaten unter Verwendung des ersten neuronalen Netzwerkblocks des Maschinenlernmodells, um eine erste neuronale Netzwerkblockausgabe zu erzeugen;
Verarbeiten (S8.3) der empfangenen Eingangsdaten unter Verwendung des zweiten neuronalen Netzwerkblocks des Maschinenlernmodells, um eine zweite neuronale Netzwerkblockausgabe zu erzeugen;
Kombinieren (S8.4) der ersten neuronalen Netzwerkblockausgabe und der zweiten neuronalen Netzwerkblockausgabe unter Verwendung des linearen Transformationsblocks, um ein vorverzerrtes Signal zur Verstärkung durch den Leistungsverstärker zu erzeugen, wobei eine Verstärkung des vorverzerrten Signals durch den Leistungsverstärker ein verstärktes Signal produziert;
Empfangen (S8.6) von Daten, die das verstärkte Signal repräsentieren; und
Anpassen (S8.7) der linearen Transformationskoeffizienten des linearen Transformationsblocks auf Basis der Daten, die das verstärkte Signal repräsentieren.

**Revendications**

1. Appareil comprenant des moyens pour :
effectuer une pré-distorsion d'un signal d'entrée qui doit être amplifié par un amplificateur de puissance (202) :

en traitant (S8.2), par un premier bloc de réseau neuronal (302) comprenant de multiples couches de réseau neuronal convolutif, des données d'entrée représentant des signaux en phase, I, et en quadrature, Q, du signal d'entrée pour générer une première sortie de bloc de réseau neuronal ;
en traitant (S8.3), par un deuxième bloc de réseau neuronal (304) comprenant au moins une couche de réseau neuronal convolutif dilatée, les données d'entrée pour générer une deuxième sortie de bloc de réseau neuronal ; et
en combinant (S8.4) la première sortie de bloc de réseau neuronal et la deuxième sortie de bloc de réseau neuronal à l'aide d'un bloc de transformation linéaire (306) ayant plusieurs coefficients de transformation linéaire, pour générer un signal pré-distordu à amplifier par l'amplificateur de puissance, dans lequel l'amplification du signal pré-distordu par l'amplificateur de puissance produit un signal amplifié,
dans lequel les moyens sont en outre configurés pour :

recevoir (S8.6) des données représentant le signal amplifié ; et
sur la base des données représentant le signal amplifié, adapter (S8.7) les coefficients de transformation linéaire du bloc de transformation linéaire.

2. Appareil selon la revendication 1, dans lequel le traitement des données d'entrée par le premier bloc de réseau neuronal pour générer la première sortie de bloc de réseau neuronal comprend :

le traitement, par un premier chemin de traitement de réseau neuronal du premier bloc de réseau neuronal, des données d'entrée pour générer une sortie de premier chemin de traitement de réseau neuronal ;
sur la base des données d'entrée, la détermination de deuxièmes données d'entrée représentant des valeurs de puissance des signaux I et Q des données d'entrée ;
le traitement, par un deuxième chemin de traitement de réseau neuronal du premier bloc de réseau neuronal, des deuxièmes données d'entrée pour générer une sortie de deuxième chemin de traitement de réseau neuronal ; et
la combinaison de la sortie de premier chemin de traitement de réseau neuronal et de la sortie de deuxième chemin de traitement de réseau neuronal pour générer la première sortie de bloc de réseau neuronal.

3. Appareil selon la revendication 2, dans lequel la sortie de premier chemin de traitement de réseau neuronal et la sortie de deuxième chemin de traitement de réseau neuronal sont combinées par multiplication.

4. Appareil selon la revendication 2 ou la revendication 3, dans lequel le premier chemin de traitement de réseau neuronal comprend une ou plusieurs couches de réseau neuronal convolutif, et le deuxième chemin de traitement de réseau neuronal comprend une ou plusieurs couches de réseau neuronal convolutif.

5. Appareil selon la revendication 1, dans lequel les coefficients des premier et deuxième blocs de traitement de réseau neuronal ne sont pas adaptés.

6. Appareil selon la revendication 1 ou la revendication 5, dans lequel les coefficients de transformation linéaire du bloc de transformation linéaire sont adaptés en utilisant une méthode des moindres carrés moyens.

7. Appareil selon l'une des revendications 1, 5 ou 6, dans lequel les coefficients du premier bloc de réseau neuronal et du deuxième bloc de réseau neuronal et les coefficients de transformation linéaire initiaux du bloc de transformation linéaire ont été déterminés pendant un entraînement de bout en bout.

8. Appareil selon l'une des revendications 1, 5, 6 ou 7, dans lequel le premier bloc de réseau neuronal, le deuxième bloc de réseau neuronal et le bloc de transformation linéaire ont été entraînés de bout en bout pour imiter une pré-distorsion numérique idéale pour l'amplificateur de puissance.

9. Appareil selon la revendication 8, dans lequel le premier bloc de réseau neuronal, le deuxième bloc de réseau neuronal et le bloc de transformation linéaire ont été entraînés :

en faisant passer un échantillon de données d'entraînement d'entrée représentant des signaux I et Q d'une partie de signal d'entrée d'entraînement par le premier bloc de réseau neuronal ;
en faisant passer l'échantillon de données d'entraînement d'entrée par le deuxième bloc de réseau neuronal ;
en traitant des sorties du premier bloc de réseau neuronal et du deuxième bloc de réseau neuronal à l'aide du bloc de transformation linéaire pour générer une partie de signal de sortie d'entraînement pré-distordu ;
en comparant la partie de signal de sortie d'entraînement pré-distordu avec une partie de signal pré-distordu idéal pour l'amplificateur de puissance ; et
en mettant à jour les coefficients d'un ou plusieurs parmi le premier bloc de réseau neuronal, le deuxième bloc de réseau neuronal et le bloc de transformation linéaire sur la base de la comparaison.

10. Appareil selon la revendication 9, dans lequel la partie de signal pré-distordu idéal a été obtenue en effectuant de multiples itérations :

du traitement d'un signal cyclique à l'aide d'un algorithme de pré-distorsion pour générer un signal cyclique pré-distordu ;
du passage du signal cyclique pré-distordu par un amplificateur de puissance pour générer un signal cyclique amplifié ;
de la comparaison du signal cyclique amplifié avec le signal cyclique ;
de l'optimisation de l'algorithme de pré-distorsion sur la base de la comparaison.

11. Appareil selon la revendication 10, dans lequel la partie de signal d'entrée d'entraînement est une partie du signal cyclique, et la partie de signal de sortie pré-distordu idéal est la sortie de l'algorithme de pré-distorsion optimisé résultant du traitement de la partie du signal cyclique.

12. Appareil selon l'une des revendications précédentes, dans lequel la fonction d'activation pour au moins certaines des couches de réseau neuronal convolutif est une fonction d'activation tanh.

13. Appareil selon l'une des revendications précédentes, dans lequel au moins certaines des couches de réseau neuronal convolutif appliquent une convolution séparable en profondeur.

14. Appareil selon l'une des revendications précédentes, dans lequel l'appareil est un circuit intégré à application spécifique ou un réseau de portes programmables.

**15.** Support de mémoire non transitoire stockant un code lisible par ordinateur et un modèle appris par machine, le modèle appris par machine comprenant :

un premier bloc de réseau neuronal (302) comprenant de multiples couches de réseau neuronal convolutif ;

un deuxième bloc de réseau neuronal (304) comprenant au moins une couche de réseau neuronal convolutif dilatée ; et

un bloc de transformation linéaire (306) ayant plusieurs coefficients de transformation linéaire,

dans lequel le code lisible par ordinateur, lorsqu'il est exécuté, amène l'au moins un processeur à :

recevoir (S8.1) des données d'entrée représentant des signaux en phase, I, et en quadrature, Q, d'un signal d'entrée qui doit être amplifié par un amplificateur de puissance (202) ;

traiter (S8.2) les données d'entrée reçues à l'aide du premier bloc de réseau neuronal du modèle appris par machine pour générer une première sortie de bloc de réseau neuronal ;

traiter (S8.3) les données d'entrée reçues à l'aide du deuxième bloc de réseau neuronal du modèle appris par machine pour générer une deuxième sortie de bloc de réseau neuronal ;

à l'aide du bloc de transformation linéaire, combiner (S8.4) la première sortie de bloc de réseau neuronal et la deuxième sortie de bloc de réseau neuronal pour générer un signal pré-distordu à amplifier par l'amplificateur de puissance, dans lequel l'amplification du signal pré-distordu par l'amplificateur de puissance produit un signal amplifié ;

recevoir (S8.6) des données représentant le signal amplifié ; et

sur la base des données représentant le signal amplifié, adapter (S8.7) les coefficients de transformation linéaire du bloc de transformation linéaire.

FIG. 1A

FIG. 1B

**FIG. 2**

**FIG. 3**

302

P(I,Q)

CNN Layer 1
(Power Path)
302B-1

CNN Layer N
(Power Path)
302B-N

400

404

402

$I_u$

$Q_u$

CNN Layer 1
(I Q Path)
302A-1

CNN Layer N
(I Q Path)
302A-N

## FIG. 4A

304

$I_u$

$Q_u$

DCN Layer 1
304-1

DCN Layer N
304-N

## FIG. 4B

**FIG. 5**

FIG. 6

e.g. 302A-1

```
┌─────────────────────────────────────┐
│                                     │
│  Obtaining ideal pre-distorted      │
│  signal for the power amplifier     │
│                                     │
│                            S7.1     │
└─────────────────────────────────────┘
                 │
                 ▼
┌─────────────────────────────────────┐
│                                     │
│  Obtaining training examples        │
│                                     │
│                            S7.2     │
└─────────────────────────────────────┘
                 │
                 ▼
┌─────────────────────────────────────┐
│                                     │
│  Pass training examples through     │
│  model                              │
│                                     │
│                            S7.3     │
└─────────────────────────────────────┘
                 │
                 ▼
┌─────────────────────────────────────┐
│  Compare pre-distorted training     │
│  output signal portion with         │
│  corresponding portion of ideal     │
│  pre-distorted signal               │
│                            S7.4     │
└─────────────────────────────────────┘
                 │
                 ▼
┌─────────────────────────────────────┐
│                                     │
│  Update coefficients of model       │
│                                     │
│                            S7.5     │
└─────────────────────────────────────┘
                 │
                 ▼
            ◇ Training Finished?
              S7.6
                 │
                 ▼
        ┌──────────────────┐
        │  Output model     │
        │           S7.7    │
        └──────────────────┘
```

**FIG. 7**

**Receive I and Q input data**

S8.1

**Process I and Q input data using a first neural network block comprising multiple CNN layers**

S8.2

**Process I and Q input data using a first neural network block comprising at least one DCN layer**

S8.3

**Process first neural network block output and second neural network block out using linear transformation block to generate a pre-distorted signal**

S8.4

**Output pre-distorted signal for amplification**

S8.5

**Receive data representing the amplified signal**

S8.6

**Adapt linear transformation coefficients of the linear transformation block**

S8.7

# FIG. 8

**FIG. 9**

EP 4 320 723 B1

**FIG. 10**

**FIG. 11**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2538553 A1

**Non-patent literature cited in the description**

- **DING, L.** ; **MA, Z** ; **MORGAN, D.R.** ; **ZIERDT, M.** ; **PASTALAN, J.** A least-squares/Newton method for digital predistortion of wideband signals. *IEEE Transactions on communications*, 2006, vol. 54 (5), 833-840
- **LE DUE, H.** ; **FEUVRIE, B.** ; **PASTORE, M.** ; **WANG, Y.** An adaptive cascaded ILA-and DLA-based digital predistorter for linearizing an RF power amplifier.. *IEEE Transactions on Circuits and Systems I: Regular Papers*, 2018, vol. 66 (3), 1031-1041
- **KINGMA, D.P.** ; **BA, J.** Adam: A method for stochastic optimization.. *In Proceedings of the 3rd International Conference on Learning Representations*, 2015
- **HE, K.** ; **ZHANG, X.** ; **REN, S.** ; **SUN, J.** Delving deep into rectifiers: Surpassing human-level performance on ImageNet classification.. *Proceedings of the IEEE international conference on computer vision*, 2015, 1026-1034